# EUROPEAN PATENT APPLICATION

(11) **EP 2 669 957 A2**
(43) Date of publication of application: **04.12.2013**
(21) Application number: 12739255.3
(22) Date of filing: 20.01.2012
(51) Int. Cl.: H01L 31/042, H01L 31/18

(54) **SOLAR CELL AND METHOD OF MANUFACTURING SAME**

(30) Priority: 24.01.2011 KR 20110006994
(71) Applicant: LG Innotek Co., Ltd., Seoul 100-714 (KR)
(72) Inventor: BAE, Do Won, Seoul 100-714 (KR)
(74) Representative: Novagraaf Technologies
(86) International application number: PCT/KR2012/000550
(87) International publication number: WO 2012/102533

(57) **Abstract**

A solar cell includes a substrate; a back electrode layer, a light absorbing layer, and a transparent electrode layer sequentially formed on the substrate; and a barrier layer formed between the substrate and the back electrode layer and including a group II element. The barrier layer is formed on the substrate to prevent diffusion of a metal. Accordingly, the efficiency of the solar cell can be prevented from being deteriorated due to a metal component contained in the substrate.

## Description

### [Technical Field]

The embodiment relates to a solar cell and a method for manufacturing the same.

### [Background Art]

In general, a solar cell converts solar energy into electrical energy. Recently, as energy consumption is increased, the solar cell has been extensively used commercially.

A solar cell according to the related art is formed by forming a semiconductor layer on a transparent substrate. A metal substrate, a glass substrate, or a plastic substrate is used as the transparent substrate.

However, when forming the semiconductor layer on the metal substrate, a metal component contained in the substrate is absorbed in the semiconductor layer, thereby deteriorating the efficiency of the solar cell.

### [Disclosure]

### [Technical Problem]

The embodiment provides a solar cell capable of preventing the efficiency from being deteriorated due to a metal component contained in a substrate and a method for manufacturing the same.

### [Technical Solution]

According to the embodiment, there is provided a solar cell including: a substrate; a back electrode layer, a light absorbing layer, and a transparent electrode layer sequentially formed on the substrate; and a barrier layer formed between the substrate and the back electrode layer and including a group II element.

According to the embodiment, there is provided a method for manufacturing a solar cell, including: preparing a metal substrate; forming a barrier layer including a group II element on the metal substrate; and sequentially forming a back electrode layer, a light absorbing layer, and a transparent electrode layer on the barrier layer.

### [Advantageous Effects]

In the solar cell according to the embodiment, a barrier layer for preventing diffusion of a metal is formed on the substrate, so that the efficiency of the solar cell can be prevented from being deteriorated due to a metal component contained in the substrate.

Further, in the solar cell according to the embodiment, the barrier layer contains a sodium (Na) component so that the efficiency of the solar cell can be improved due to diffusion of the Na component.

### [Description of Drawings]

FIG. 1 is a sectional view showing a solar cell on which a barrier layer is formed according to an embodiment of the invention;

FIG. 2 is sectional view showing the barrier layer according to the embodiment of the invention;

FIGS. 3 to 6 are sectional views showing modified examples of a barrier layer according to the embodiment of the invention; and

FIGS. 7 to 12 are sectional views showing a method of manufacturing a solar cell according to an embodiment of the invention.

### [Best Mode]

### [Mode for Invention]

In the description of the embodiments, it will be understood that, when a panel, a wire, a cell, a device, a surface, or a pattern is referred to as being "on" or "under" another panel, another wire, another cell, another device, another surface, or another pattern, it can be "directly" or "indirectly" on the other panel, wire, cell, device, surface, or pattern, or one or more intervening layers may also be present. Such a position of the constituent element has been described with reference to the drawings. The size of the elements shown in the drawings may be exaggerated for the purpose of explanation and may not utterly reflect the actual size.

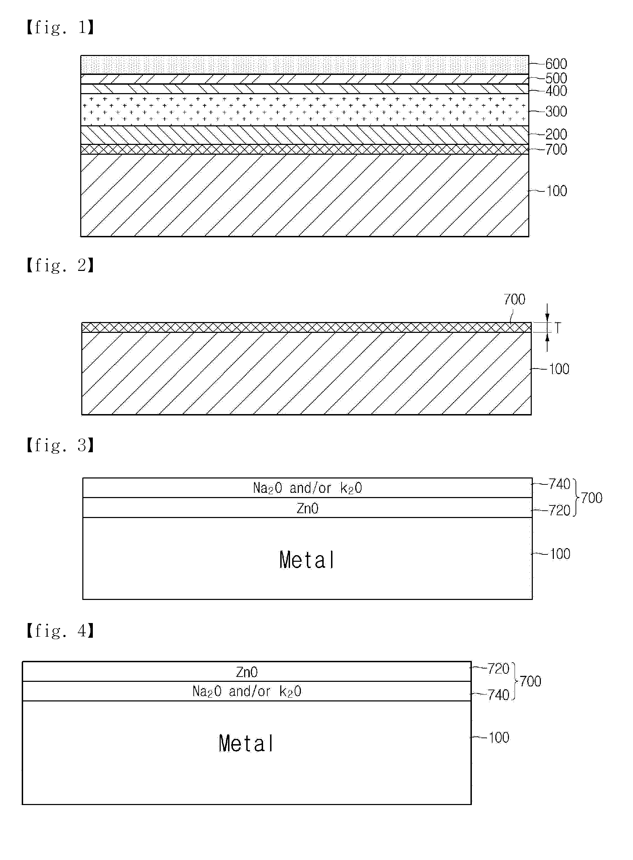

FIG. 1 is a sectional view showing a solar cell on which a barrier layer is formed according to an embodiment of the invention, FIG. 2 is sectional view showing the barrier layer according to the embodiment of the invention, and FIGS. 3 to 6 are sectional views showing modified examples of a barrier layer according to the embodiment of the invention.

Referring to FIG. 1, the solar cell according to the embodiment includes a substrate 100 as well as a back electrode layer 200, a light absorbing layer 300, and a transparent electrode layer 600 which are sequentially formed on the substrate 100, and a barrier layer 700 formed between the substrate 100 and the back electrode layer 200 to prevent diffusion of a metal component contained in the substrate 100. A first buffer 400 and a second buffer layer 500 may be further formed on the light absorbing layer 300.

The substrate 100 has a rectangular plate shape and may include a transparent material. A metal substrate containing a metal component may be used as the substrate 100 according to the embodiment.

The back electrode layer 200 is formed on the substrate 100. The back electrode layer 200 serves as an n-type electrode, and may include molybdenum (Mo).

The back electrode layer 200 may include at least one of aluminum (Al), nickel (Ni), chromium (Cr), titanium (Ti), silver (Ag), and gold (Au) being a conductive material in addition to the Mo. The back electrode layer 200 may be formed to provide at least two layers using homogeneous or heterogeneous metal.

The light absorbing layer 300 is formed on the back electrode layer 200. The light absorbing layer 300 may have a group I-III-VI compound. The light absorbing layer 300 may include at least one of CIGS, CIGSS, CZTS, CIS, CGS, and CdTe.

For example, the light absorbing layer 300 may include at least one material selected from the group consisting of CdTe, CuInSe₂, Cu(In,Ga)Se₂, Cu(In,Ga)(Se,S)₂, Ag(InGa)Se₂, Cu(In,Al)Se₂, and CuGaSe₂.

A first buffer layer 400 and a second buffer layer 500 may be sequentially formed on the light absorbing layer 300. The first buffer layer 400 may be formed by using a material including cadmium sulfide (CdS). The first buffer layer 400 may include a material such as CdSe, ZnS, ZnSe, or ZnMgxOy in addition to the CdS.

The first buffer layer 400 may have an energy bandgap in the range of about 1.9 eV to about 2.3 eV corresponding to the intermediate energy bandgap between the back electrode layer 200 and the transparent electrode layer 600. The first buffer layer 400 may include at least two layers.

The second buffer layer 500 is formed of ZnO to have a high resistance. The second buffer layer 500 may insulate the transparent electrode layer 600 to be described later and prevent shock damage. The second buffer 500 may be omitted according to a type of the first buffer 400.

The transparent electrode layer 600 is formed on the second buffer layer 500. The transparent electrode layer 600 includes a transparent conductive material, or may include aluminum doped zinc oxide (AZO; ZnO:Al). The transparent electrode layer 600 may be formed by using GZO, BZO, FTO, or ITO as well as the AZO.

A material of the transparent electrode layer 600 is not limited to the above-mentioned material. That is, the transparent electrode layer 600 may be formed by using one of zinc oxide (ZnO), tin oxide (SnO₂), and indium tin oxide (ITO), each of which has high light transmittance and electric conductivity.

Meanwhile, the barrier layer 700 according to the embodiment is formed between the substrate 100 and the back electrode layer 200. In other words, the barrier layer 700 is formed on the substrate 100.

As shown in FIG. 2, the barrier layer 700 according to the embodiment serves to prevent a metal component contained in the substrate 100 from moving into a semiconductor layer of the solar cell. To this end, the barrier layer 700 may include ZnO and may be formed on the substrate 100 to have a predetermined thickness in a range of, for example, 50 nm to 1 *µ*m.

Al₂O₃, SiO₂, and Cr may be used as the barrier layer 700 in addition to the ZnO. However, when the barrier layer 700 is formed by using Al₂O₃, SiO₂, or Cr, the barrier layer 700 has a thickness of 1 *µ*m or more in order to prevent the metal from being diffused.

However, if the ZnO is used as the barrier layer 700, the barrier layer 700 can be formed with a thickness of 1 *µ*m or less, thereby reducing a process cost and producing a thinner solar cell.

Although the foregoing embodiment has illustrated that the barrier layer 700 includes ZnO, the embodiment is not limited thereto. In order to improve the efficiency of the solar cell, the barrier layer 700 may contain a Na component. That is, the barrier layer 700 may include one or both of Na₂O having sodium component and K₂O together with ZnO.

In this manner, if the barrier layer 700 is formed to have one of Na₂O and K₂O together with ZnO, the diffusion of a metal component contained in the substrate 100 can be prevented and the Na component is supplied to the light absorbing layer 300 so that the efficiency of the solar cell can be improved. The Na component may be naturally diffused due to heat generated during a process for manufacturing the solar cell.

Contents of ZnO and Na₂O or K₂O contained in the barrier layer 700 may be flexibly determined based on a preset reference value.

Although the foregoing embodiment has described that the barrier layer 700 is formed as one layer including only ZnO, or ZnO and Na₂O or K₂O, the embodiment is not limited thereto. That is, the barrier layer 700 may have a multi-layer structure.

As shown in FIGS. 3 and 4, the barrier layer 700 is formed on the metal substrate 100 and may include a group II element. The barrier layer 700 may include a first barrier layer 720 and a second barrier layer 740.

The first barrier layer 720 includes ZnO and prevents a metal from being diffused, and the second barrier layer 740 may include one or both of Na₂O and K₂O and may diffuse sodium during the manufacturing process.

The barrier layer 700 may be configured by forming the first barrier layer 720 on the substrate 100 and forming a second barrier layer 740 on the first barrier layer 720 as shown in FIG. 3. In contrast, as shown in FIG. 4, after the second barrier layer 740 is formed on the substrate 100, the first barrier layer 720 may be formed on the second barrier layer 740.

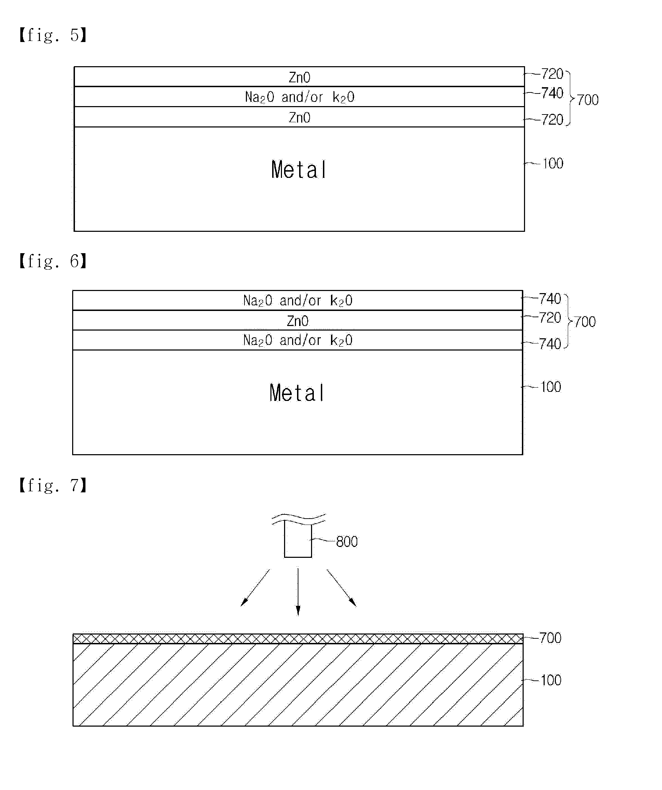

Further, as shown in FIGS. 5 and 6, the barrier layer 700 according to the embodiment may be formed as three layers on the substrate 100. The first barrier layer 720 may include ZnO and the second barrier layer 740 may include one or both of Na₂O and K₂O.

Accordingly, as shown in FIG. 5, the barrier layer 700 may be formed by sequentially laminating the first barrier layer 720, the second barrier layer 740, and the first barrier layer 720 on the substrate 100. As shown in FIG. 6, the barrier layer 700 may be configured by sequentially laminating the second barrier layer 740, the first barrier layer 720, and the second barrier layer 740.

Although the barrier layer 700 having a single-layer structure, a two-layer structure, or a three-layer structure is described in the foregoing embodiment, the embodiment is not limited thereto. In other words, the barrier layer 700 having at least four-layer structure may be formed. The barrier layer 700 having at least four-layer structure may be formed by alternately aligning the first barrier layers and the second barrier layers.

The barrier layer according to the embodiment can improve the efficiency of the solar cell by diffusing sodium while preventing power efficiency of the solar cell from being deteriorated due to diffusion of the metal component contained in the substrate.

Although the metal substrate is used in the foregoing embodiment as an example, if a substrate having no metal component is used as the substrate 100, the barrier layer may be formed to contain the Na₂O or K₂O component without the ZnO component.

Hereinafter, a method of manufacturing the solar cell according to an embodiment of the invention will be described with reference to FIGS. 7 to 12. FIGS. 7 to 12 are sectional views showing a method of manufacturing a solar cell according to the embodiment.

As a substrate 100 containing a metal component is prepared as shown in FIG. 7, a step of forming a barrier layer 700 according to the embodiment by spraying ZnO 800 on the substrate 100 is performed. The barrier layer 700 may have a thickness of 50 nm to 1 *µ*m.

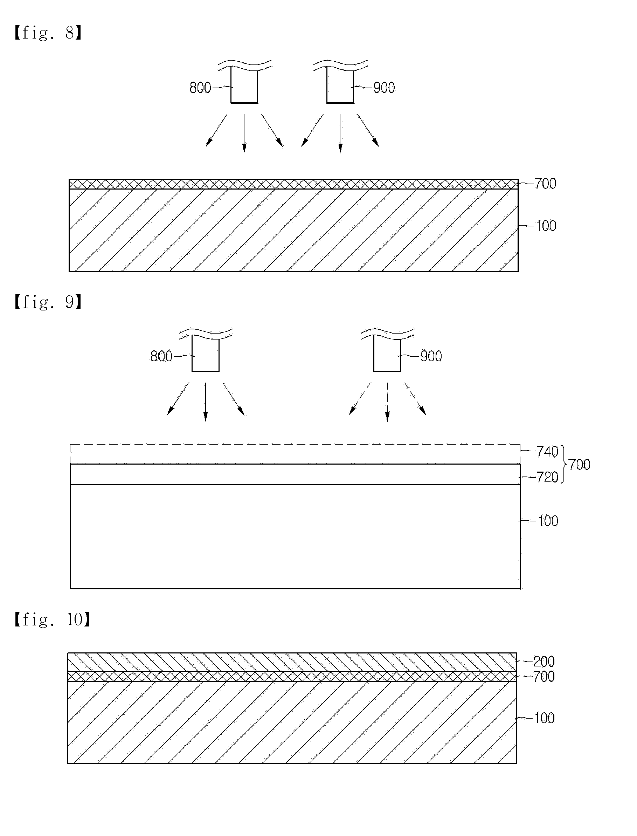

In contrast, when the barrier layer 700 is formed using a plurality of materials, as shown in FIG. 8, the barrier layer 700 may be formed by simultaneously spraying two deposition materials which are separately mounted.

Further, when the barrier layer 700 is formed as a multi-layer structure using a plurality of materials, as shown in FIG. 9, a first barrier layer 720 is formed on the substrate 100 by firstly spraying a first deposition material 800 containing ZnO. Then, after a predetermined time has elapsed, a second barrier layer 740 may be formed on the first barrier layer 720 by spraying a second deposition material 900 including one or a mixture of Na₂O and K₂O.

Accordingly, the barrier layer 700 may be formed on the substrate 100 as two layers. At least three barrier layers may be formed through the foregoing deposition process.

In this manner, if the barrier layer 700 is formed on the substrate 100, a step of depositing the back electrode layer 200 on the barrier layer 700 is performed as shown in FIG. 10. The back electrode layer 200 may be formed by depositing Mo to have a predetermined thickness of, for example, 0.7 *µ*m, for example, by a sputtering process.

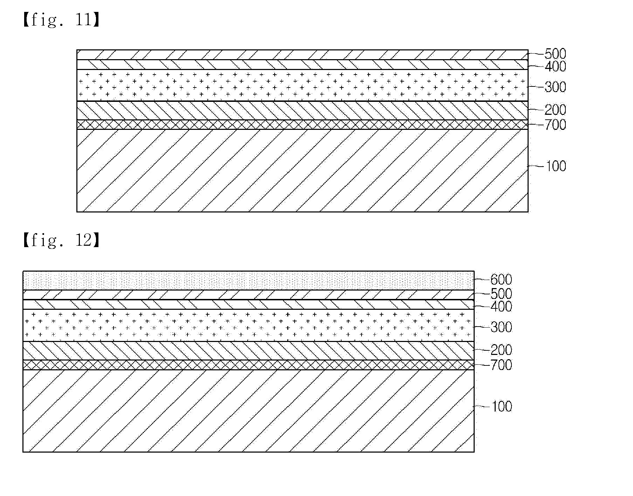

Next, as shown in FIG. 11, a step of sequentially forming the light absorbing layer 300, the first buffer 400, and the second buffer layer 500 on the back electrode layer 200 is performed. The light absorbing layer 300 may be formed by depositing CIGS using co-evaporation. The n-type first buffer layer 400 and the second buffer layer 500 may be formed on the light absorbing layer 300 by depositing cadmium sulfide (CdS) and ZnO, respectively, using a Chemical Bath Deposition (CBD) and a sputtering process.

After that, as shown in FIG. 12, a step of forming the transparent electrode layer 600 on the second buffer layer 500 is performed. The transparent electrode layer 600 may be formed on the second buffer layer 500 by depositing AZO through the sputtering process. Accordingly, the manufacturing process for the high efficiency solar cell according to the embodiment may be completed.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell comprising:
a substrate;
a back electrode layer, a light absorbing layer, and a transparent electrode layer sequentially formed on the substrate; and
a barrier layer formed between the substrate and the back electrode layer and including a Periodic table group II element.

2. The solar cell of claim 1, wherein the barrier layer has a thickness of 50 nm to 1 *µ*m.

3. The solar cell of claim 1, wherein the barrier layer comprises ZnO.

4. The solar cell of claim 3, wherein the barrier layer further comprises Na₂O or K₂O.

5. The solar cell of claim 1, wherein the barrier layer comprises a first barrier layer including ZnO and a second barrier layer including Na₂O or K₂O.

6. The solar cell of claim 5, wherein the first barrier layer and the second barrier layer are alternately formed.

7. The solar cell of claim 1, wherein the substrate comprises a metal substrate containing a metal component.

8. A method for manufacturing a solar cell, the method comprising:
preparing a metal substrate;
forming a barrier layer including a group II element on the metal substrate; and
sequentially forming a back electrode layer, a light absorbing layer, and a transparent electrode layer on the barrier layer.

9. The method of claim 8, wherein the barrier layer is formed by further depositing one of Na₂O and K₂O.

10. The method of claim 9, wherein the barrier layer is formed by simultaneously depositing the ZnO and one of the Na₂O and the K₂O.

11. The method of claim 9, wherein the barrier layer is formed by alternately depositing the ZnO and one of the Na₂O and the K₂O.
